(19) Europäisches Patentamt

European Patent Office

Office européen des brevets

(11) EP 2 780 998 B1

## (12) EUROPEAN PATENT SPECIFICATION

(45) Date of publication and mention
of the grant of the patent:
**11.05.2016 Bulletin 2016/19**

(21) Application number: **11784661.8**

(22) Date of filing: **17.11.2011**

(51) Int Cl.:
**H02H 7/26** *(2006.01)*    **G01R 31/08** *(2006.01)*

(86) International application number:
**PCT/EP2011/070391**

(87) International publication number:
**WO 2013/071974 (23.05.2013 Gazette 2013/21)**

### (54) FAULT PROTECTION IN MIXED HIGH-VOLTAGE TRANSMISSION LINES

AUSFALLSCHUTZ IN GEMISCHTEN HOCHSPANNUNGSLEITUNGEN

PROTECTION EN CAS DE DÉFAUT DANS LES LIGNES DE TRANSMISSION À HAUTE TENSION MIXTES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**24.09.2014 Bulletin 2014/39**

(73) Proprietor: **ABB Research Ltd.**
**8050 Zürich (CH)**

(72) Inventors:
• **WANG, Jianping**
**S-724 71 Västerås (SE)**
• **ALBINALI, Hussain**
**Dammam 31423 (SA)**

(74) Representative: **Ahrengart, Kenneth**
**ABB AB**
**Intellectual Property**
**Ingenjör Bååths Gata 11**
**721 83 Västerås (SE)**

(56) References cited:
**EP-A2- 0 805 355     WO-A1-2011/127967**

• **ZHENTAO XIN ET AL: "Smart re-close scheme of combined overhead line with underground power cable", POWER SYSTEM TECHNOLOGY (POWERCON), 2010 INTERNATIONAL CONFERENCE ON, IEEE, PISCATAWAY, NJ, USA, 24 October 2010 (2010-10-24), pages 1-6, XP031834272, DOI: 10.1109/POWERCON.2010.5666369 ISBN: 978-1-4244-5938-4**

## Description

### Field of the invention

The invention relates in general to travelling-wave based fault protection in high-voltage alternating current (AC) or direct current (DC) power transmission lines, and more specifically to the identification of the fault location in mixed transmission lines, i.e., transmission lines comprising both overhead lines and cables.

### Background of the invention

Mixed power transmission lines, i.e., transmission lines comprising both overhead-line sections and cable sections, have emerged recently. Their use is expected to increase in the near future, mainly driven by an increased need for network interconnections between countries, by restrictions imposed on new overhead transmission lines, and due to advancements in cable technology.

In traditional transmission lines, which are based on a single type of line, i.e., either overhead line or cable, auto-reclosing protection is utilized dependent on the type of line. Typically, a fault protection unit is employed for monitoring one or several transmission lines of a power transmission network. In the event of a fault on a transmission line, the fault protection unit trips circuit breakers located at either side of the transmission line, for the purpose of disconnecting the faulty line from the rest of the network, thereby mitigating the risk of propagation of the fault. Subsequently, depending on the type of fault, the circuit breakers may be closed in order to restore power transmission.

Typically, in overhead transmission lines most of the faults are transient faults, e.g., due to lightning, and an auto-reclosing protection scheme may therefore be applied. In transmission lines solely based on cables, on the other hand, virtually all faults are permanent, and auto-reclosing is therefore not applied.

Hence, in order to provide mixed power transmission lines with suitable fault protection, a fault protection scheme which is sensitive to the type of section where the fault occurred is desirable.

WO 2011/127967 discloses a method and apparatus for determining the distance to a fault in a power transmission system by determining the time of arrival of a fault wave in accordance with the preamble of present independent claims 1 and 4.

ZHENTAO XIN ET AL: "Smart re-close scheme of combined overhead line with underground power cable", POWER SYSTEM TECHNOLOGY (POWERCON), 2010 INTERNATIONAL CONFERENCE ON, IEEE, PISCATAWAY, NJ, USA, 24 October 2010 (2010-10-24), pages 1-6, discloses the use of a traveling wave method for precisely locating a fault location in a system with combined transmission lines.

### Summary of the invention

It is an object of the present invention to provide a more efficient alternative to the above techniques and prior art.

More specifically, it is an object of the present invention to provide an improved fault protection of mixed power transmission lines.

These and other objects of the present invention are achieved by means of a method defined in independent claim 1, and by means of a device having the features defined in independent claim 5. Embodiments of the invention are characterized by the dependent claims.

According to a first aspect of the invention, a method of fault protection in a high-voltage power transmission line is provided. The power transmission line comprises $n_s$ sections, where $n_s \geq 2$. The method comprises detecting a first time of arrival $t_1$ of a fault-induced travelling wave, detecting a second time of arrival $t_2$ of the fault-induced travelling wave, calculating a time difference $\Delta t$ between the first time of arrival and the second time of arrival, comparing the time difference $\Delta t$ to a plurality of pre-determined time differences $\Delta t_n$, and determining that the fault occurred in section $n_f$ of the transmission line. The first time of arrival $t_1$ is detected on arrival of the fault-induced travelling wave at a first end of the transmission line. The second time of arrival $t_2$ is detected on arrival of the fault-induced travelling wave at a second end of the transmission line. The time difference $\Delta t$ is calculated as $\Delta t = t_1 - t_2$. For the pre-determined time differences $\Delta t_n$, $n = 1... n_s + 1$. It is determined that the fault occurred in section $n_f$ of the transmission line if $\Delta t_{nf} < \Delta t < \Delta t_{nf+1}$.

According to a second aspect of the invention, a fault protection device for a high-voltage power transmission line is provided. The power transmission line comprises $n_s$ sections, where $n_s \geq 2$. The fault protection device comprises means for detecting a first time of arrival $t_1$, of a fault-induced travelling wave, means for detecting a second time of arrival $t_2$ of the fault-induced travelling wave, and processing means. The first time of arrival $t_1$ is detected on arrival of the fault-induced travelling wave at a first end of the transmission line. The second time of arrival $t_2$ is detected on arrival of the fault-induced travelling wave at a second end of the transmission line. The processing means is arranged for calculating a time difference $\Delta t$ between the first time of arrival and the second time of arrival, comparing the time difference $\Delta t$ to a plurality of pre-determined time differences $\Delta t_n$, and determining that the fault occurred in section $n_f$ of the transmission line. The processing means is arranged for calculating the time difference $\Delta t$ as $\Delta t = t_1 - t_2$. For the pre-determined time differences $\Delta t_n$, $n = 1... n_s + 1$. The processing means is further arranged for determining that the fault occurred in section $n_f$ of the transmission line if $\Delta t_{nf} < \Delta t < \Delta t_{nf+1}$.

The present invention makes use of an understanding that an improved fault protection for power transmission lines comprising multiple sections of mixed type, i.e., both overhead line and cable sections, may be based on an determination of a difference between the respective times of arrival of a fault-induced travelling wave at the ends of the transmission line. To this end, a fault occurring on a transmission line creates a travelling wave which propagates towards the ends of the transmission line. By detecting the time of arrival at either end of the transmission line, and by calculating the difference between the measured times of arrival, the section within which the fault occurred may be identified by comparing the measured time difference to pre-determined time differences corresponding to the junctions between adjacent sections of the transmission line as well as the two ends of the transmission line.

An embodiment of the invention is advantageous in that an identification of the faulty section may be performed in a more reliable fashion than what is known from prior-art solutions based on distance relays or differential relays. Further, an embodiment of the invention is advantageous in that it is less expensive than solutions based on differential relays, which require means for detecting a fault at each junction between two adjacent sections of the transmission line. An embodiment of the present invention, on the contrary, is based on measurements performed at the ends of the transmission line only, irrespective of the number of sections comprised in the transmission line.

The pre-determined time differences $\Delta t_n$, which are used in identifying the faulty section, may be pre-calculated once the design of the transmission line, in terms of the number of sections, the length of each section, and the propagation velocity of a traveling wave in each section, is known. Optionally, the pre-determined time differences $\Delta t_n$ may be determined by measurement after the transmission line has been set up. This may be achieved by creating traveling waves at locations near the junctions between adjacent sections of the transmission line and measuring the resulting time differences. It will also be appreciated by the person skilled in the art that the sequence of time differences $\Delta t_n$, where $n = 1... n_s + 1$ and $n_s$ is the number of sections of the transmission line, is strictly monotonous, i.e., $\Delta t_1 < \Delta t_2 < ... < \Delta t_{n_s} < \Delta t_{n_s+1}$.

According to an embodiment of the invention, each pre-determined time difference $\Delta t_n$ is the difference between the first time of arrival and the second time of arrival of a traveling wave induced by a fault occurring at a junction $n$. Specifically, $n = 1$ corresponds to the first end of the transmission line, $n = n_s + 1$ corresponds to the second end of the transmission line, and $n = 2 ... n_s$ is the junction between two adjacent sections $n - 1$ and $n$ of the transmission line. In other words, for each junction of the transmission line, including the ends of the transmission line, a time difference is pre-determined for a fault occurring at the respective junction. The pre-determined time differences are then used for identifying the faulty section.

According to an embodiment of the invention, the method further comprises initiating protective measures. The protective measures are initiated in response to determining that a fault occurred in section $n_f$ of the transmission line. The protective measures are dependent on a type of section $n_f$. Taking the type of section into account when initiating protective measures in response to a fault is advantageous in that different types of transmission line sections may have different protective measures associated with them.

According to an embodiment of the invention, each section of the transmission line is either one of a cable section or an overhead-line section. Further, in the initiating protective measures, auto-reclosing is activated if section $n_f$ is an overhead-line section, and auto-reclosing is deactivated if section $n_f$ is a cable section. This is advantageous in that most faults which occur in overhead transmission lines are transient faults, e.g., due to lightning, and auto-reclosing may therefore be applied, whereas virtually all faults in cable lines are permanent, for which auto-reclosing is senseless.

Further objectives of, features of, and advantages with, the present invention will become apparent when studying the following detailed disclosure, the drawings and the appended claims. Those skilled in the art realize that different features of the present invention can be combined to create embodiments other than those described in the following.

Brief description of the drawings

The above, as well as additional objects, features and advantages of the present invention, will be better understood through the following illustrative and non-limiting detailed description of embodiments of the present invention, with reference to the appended drawings, in which:

Fig. 1 illustrates a power transmission line in accordance with an embodiment of the invention.

Fig. 2 illustrates a fault protection device in accordance with an embodiment of the invention.

All the figures are schematic, not necessarily to scale, and generally only show parts which are necessary in order to elucidate the invention, wherein other parts may be omitted or merely suggested.

Detailed description

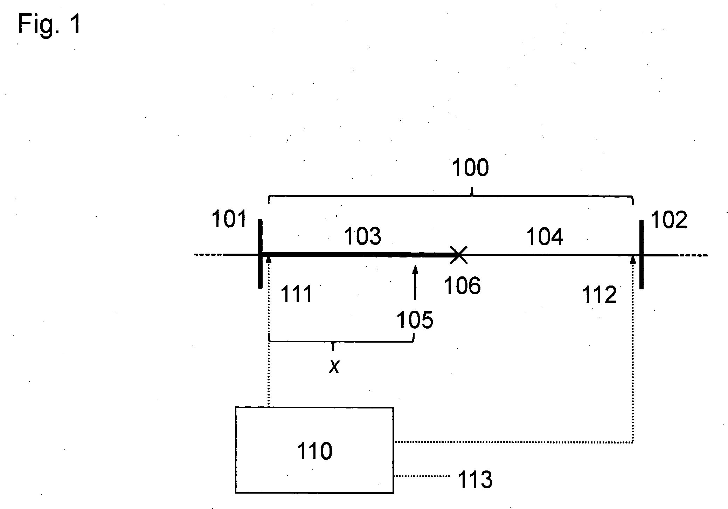

In Fig. 1, a high-voltage power transmission line in accordance with an embodiment of the invention is illustrated.

Power transmission line 100 connects two terminals 101 and 102, such as switchyards, converters, or transformers, and comprises two sections 103 and 104. Sections 103 and 104 may be of different types, such as overhead line or cable. For instance, section 103 may be a cable, whereas section 104 is an overhead line. The two sections 103 and 104 are interconnected at junction 106.

In case of a fault on transmission line 100, e.g., a fault at location 105 within section 103, a traveling wave is created which travels towards both ends 101 and 102 of transmission line 100. In order to detect the respective times of arrival of the traveling wave at ends 101 and 102, sensor means 111 and 112 are provided for detecting the arrival of the traveling wave at either end, i.e., terminal, of transmission line 100. More specifically, end 101 is provided with sensor means 111 for detecting the arrival of the traveling wave at end 101 of transmission line 100, and end 102 is provided with sensor means 112 for detecting the arrival of the traveling wave at end 102.

Further with reference to Fig. 1, processing means 110 is provided which is arranged for measuring the time of arrival $t_1$ at end 101, and the time of arrival at end $t_2$. Processing means 110 is further arranged for calculating a difference

$$\Delta t = t_1 - t_2 \quad (1)$$

between the time of arrival $t_1$ at the first end 101 and the time of arrival $t_2$ at the second end 102. Based on the calculated time difference $\Delta t$, the fault location may be determined, i.e., the section in which the fault has occurred may be identified.

To this end, means 110 is arranged for comparing the calculated time difference $\Delta t$ to pre-determined time differences $\Delta t_n$, where $n = 1...n_s + 1$ and $n_s$ is the number of sections of the transmission line. For transmission line 100 illustrated in Fig. 1, $n_s = 2$, and the measured time difference $\Delta t$ is compared to three pre-determined time differences $\Delta t_1$, $\Delta t_2$, and $\Delta t_3$. $\Delta t_1$ is the time difference which a traveling wave originating at the first end 101 would give rise to. Correspondingly, $\Delta t_3$ is the time difference which a traveling wave originating at the second end 102 would give rise to. Finally, $\Delta t_2$ is the time difference which a traveling wave originating at junction 106, between the first section 103 and the second section 104, would give rise to.

If the measured time difference $\Delta t$ is larger than $\Delta t_1$ but smaller than $\Delta t_2$, $\Delta t_1 < \Delta t < \Delta t_2$, processing means 110 is arranged for determining that the fault has occurred in the first section 103, i.e., between end 101 and junction 106. Correspondingly, processing means 110 is arranged for determining that the fault has occurred in the second section 104, i.e., between junction 106 and end 102, if $\Delta t_2 < \Delta t < \Delta t_3$.

In the following, the relation between the difference in time of arrival $\Delta t$ and the location x of the fault along the transmission line is described with reference to Fig. 1, i.e., transmission line 100 comprising two sections, a cable section 103 of length $l_c$, and an overhead-line section 104 of length $l_{oh}$.

If the fault is located within the cable section 103 of transmission line 100, the time of arrival $t_1$, of the travelling wave at the first end 101, to which cable section 103 is connected, is given by

$$t_1 = \frac{x}{v_c} + t_0 \quad (2),$$

where x is the distance of fault location 105 from the first end 101, $v_c$ is the propagation velocity of the travelling wave within the cable section 103, and $t_0$ is the time when the travelling is created, i.e., the fault incidence.

Correspondingly, the time of arrival $t_2$ of the travelling wave at the second end 102, to which the overhead-line section 104 is connected, is given by

$$t_2 = \frac{l_c - x}{v_c} + \frac{l_{oh}}{v_{oh}} + t_0 \quad (3),$$

where $v_{oh}$ is the propagation velocity of the travelling wave within the overhead-line section 104. Hence, the time difference (Eq. (1)) can be calculated as

$$\Delta t = \frac{2x}{v_c} - \left[\frac{l_c}{v_c} + \frac{l_{oh}}{v_{oh}}\right] \quad (4),$$

If, on the other hand, the fault is located within the overhead-line section 104, the time difference can be calculated as

$$\Delta t = \frac{2x}{v_{oh}} + \left[\frac{l_c}{v_c} - \frac{2l_c + l_{oh}}{v_{oh}}\right] \quad (5),$$

In general, a power transmission line in accordance with an embodiment of the invention may comprise any number of sections, each of the sections being of either one of a cable, an overhead line, or any other type of transmission line suitable for high-voltage power transmission. It will be appreciated by the person skilled in the art that equations corresponding to Eqs. (2) and (3) may easily be derived for transmission lines comprising any number of sections. Generally, the relation between time difference $\Delta t$ and fault location x along the transmission line may be expressed as

$$\Delta t = k_1 x - k_2 \quad (6),$$

where $k_1$ and $k_2$ are constants which are dependent on the fault location, the number and type of sections, and the propagation velocity of the travelling wave in each section. If constants $k_1$ and $k_2$ are known, the fault location $x$ may be determined by measuring the time difference $\Delta t$ and applying Eq. (6).

The sequence of pre-determined time differences $\Delta t_n$ applicable for transmission line 100 may be calculated using Eqs. (4) and (5). More specifically, $\Delta t_1$, which corresponds to a traveling wave originating at the first end 101, is obtained by setting x = 0 in Eq. (4):

$$\Delta t_1 = -\left[\frac{l_c}{v_c} + \frac{l_{oh}}{v_{oh}}\right] \quad (7).$$

Further, $\Delta t_3$, which corresponds to a traveling wave originating at the second end 102, is obtained by setting $x = l_c + l_{oh}$ in Eq. (5):

$$\Delta t_3 = \frac{l_c}{v_c} + \frac{l_{oh}}{v_{oh}} \quad (8).$$

Finally, $\Delta t_2$, which corresponds to a traveling wave originating at junction 106, may be obtained by setting $x = l_c$ in either Eq. (4) or (5):

$$\Delta t_2 = \frac{l_c}{v_c} - \frac{l_{oh}}{v_{oh}} \quad (9).$$

For transmission lines comprising any number of sections, corresponding equations for calculating the sequence of $\Delta t_n$ may easily be derived.

Further with reference to Fig. 1, fault protection device 110 may be arranged for initiating protective measures in response to identifying the faulty section. In particular, such protective measures may be initiated dependent on the type of the faulty section. For instance, if a fault 105 has occurred in the first section 103, which is based on a cable, fault protection device 110 may be arranged for tripping circuit breakers arranged at ends 101 and 102 of transmission line 100, thereby disconnecting the faulty transmission line from other parts of the power transmission network. The tripping of the circuit breakers may be achieved by sending trip signal 113 to the circuit breakers, or by sending signal 113 to an external fault protection unit: Since faults in cable sections almost exclusively are permanent, auto-reclosing is not applied and the reason for the fault has to be investigated before transmission line 100 is re-connected. If, on the other hand, fault protection device 110 has detected a fault within overhead-line section 104, auto-reclosing may be applied. To this end, fault protection device 110 may be arranged for tripping circuit breakers located at ends 101 and 102 of transmission line 100 by sending trip signal 113 to the circuit breakers, or by sending signal 113 to an external fault protection unit, and for re-closing the circuit breakers after the fault current has been cleared.

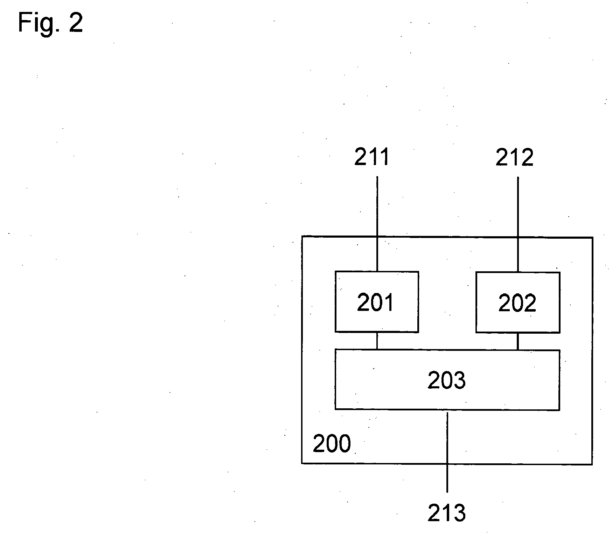

With reference to Fig. 2, an embodiment of a fault protection device, such as fault protection device 110 described with reference to Fig. 1, is illustrated.

Fault protection device 200 comprises means 201 for measuring a first time of arrival $t_1$, e.g., via sensor 211, and means 202 for measuring a second time of arrival $t_2$, e.g., via sensor 212. Further, fault protection device 200 comprises processing means 203 which is arranged for calculating a time difference $\Delta t$ between the first time of arrival $t_1$ and the second time of arrival $t_2$, and for comparing the calculated time difference $\Delta t$ to a sequence of pre-determined time differences $\Delta t_n$, as was described hereinbefore. Fault protection device 200 may further be arranged for initiating protective measures by sending a trip signal 213 to circuit breakers, or by communicating via signal 213 with an external fault protection unit.

It will be appreciated by the person skilled in the art that means 201 and 202 for measuring times of arrival, as well as processing means 203, may be implemented by electronic components, integrated circuits (IC), application specific integrated circuits (ASIC), field programmable gate arrays (FPGA), and/or complex programmable logic devices (CPLD), or any combination thereof. It will also be appreciated that the corresponding functionality can, at least in part, be replaced by an appropriate software.

The person skilled in the art realizes that the present invention by no means is limited to the embodiments described above. On the contrary, many modifications and variations are possible within the scope of the appended claims. For example, one may easily envisage embodiments of the invention which are designed to serve as a complement to an existing fault protection system. For instance, a fault protection device in accordance with an embodiment of the invention may be arranged for identifying the faulty section, as was described hereinbefore, and sending a signal to an existing fault protection system so as to activate or deactivate auto-reclosing, depending on whether the fault section is an overhead line or a cable, respectively.

In conclusion, an improved method of fault protection in high-voltage power transmission lines comprising multiple sections of different type, i.e., cable or overhead line, is provided. The method comprises determining a time difference $\Delta t$ between a first time of arrival of a fault-induced travelling wave at a first end of the transmission line and a second time of arrival of the fault-induced travelling wave at a second end of the transmission line, comparing the measured time difference to a plurality pre-determined time differences $\Delta t_n$, wherein each time difference $\Delta t_n$ corresponds to a junction between adjacent sections of the transmission line, and determining that the fault occurred in section $n_f$ of the transmission line if $\Delta t_{nf} < \Delta t < \Delta t_{nf+1}$. Further, a fault protection device is provided.

## Claims

1. A method of fault protection in a high-voltage power transmission line (100) comprising $n_s \geq 2$ sections (103, 104), the method comprising:

   detecting, at a first end (101) of the transmission line, an arrival of a fault-induced (105) travelling wave at a first time of arrival $t_1$,
   detecting, at a second end (102) of the transmission line, an arrival of the fault-induced travelling wave at a second time of arrival $t_2$,
   calculating a time difference $\Delta t$ between the first time of arrival and the second time of arrival, $\Delta t = t_1 - t_2$,
   determining that the fault (105) occurred in section $n_f$ (103) of the transmission line,
   **characterized by**
   comparing the time difference $\Delta t$ to a plurality of pre-determined time differences $\Delta t_n$, where $n = 1 \ldots ns + 1$,
   determining that the fault (105) occurred in section $n_f$ (103) of the transmission line if $\Delta t_{nf} < \Delta t < \Delta t_{nf+1}$
   wherein each pre-determined time difference $\Delta t_n$ is the difference between the first time of arrival and the second time of arrival of a traveling wave induced by a fault occurring at a junction $n$ (101, 102, 106), where $n = 1$ corresponds to the first end (101) of the transmission line, $n = n_s + 1$ corresponds to the second end (102) of the transmission line, and $n = 2 \ldots n_s$ is the junction (106) between two adjacent sections $n - 1$ (103) and $n$ (104) of the transmission line, the time differences being pre-calculated based on the length of and propagation velocity of a traveling wave in each section.

2. The method according to claim 1, further comprising:

   initiating, in response to determining that a fault occurred in section $n_f$ of the transmission line, protective measures, wherein the protective measures are dependent on a type of section $n_f$.

3. The method according to claim 2, wherein each section (103, 104) of the transmission line is either one of a cable section (103) or an overhead-line section (104), and wherein, in the initiating protective measures, auto-reclosing is activated if section $n_f$ is an overhead-line section and auto-reclosing is deactivated if section $n_f$ is a cable section.

4. A fault protection device (200) for a high-voltage power transmission line (100) comprising $n_s > 2$ sections (103, 104), the fault protection device comprising:

   first means (201) for detecting, at a first end (101) of the transmission line, an arrival of a fault-induced (105) travelling wave at a first time of arrival $t_1$,
   second means (202) for detecting, at a second end (102) of the transmission line, an arrival of the fault-induced travelling wave at a second time of arrival $t_2$,
   processing means (203) being arranged for:

   calculating a time difference $\Delta t$ between the first time of arrival and the second time of arrival, $\Delta t = t_1 - t_2$,
   determining that the fault occurred in section $n_f$ (103) of the transmission line,
   **characterized in that**
   the processing means (2013) is further arranged for
   comparing the time difference $\Delta t$ to a plurality of pre-determined time differences $\Delta t_n$, where $n = 1 \ldots ns + 1$,
   determining that the fault occurred in section $nf$ (103) of the transmission line if $\Delta t_{nf} < \Delta t < \Delta t_{nf+1}$,
   wherein each pre-determined time difference $\Delta t_n$ is the difference between the first time of arrival and the second time of arrival of a traveling wave induced by a fault occurring at a junction n (101, 102, 106), where $n = 1$ corresponds to the first end (101) of the transmission line, $n = n_s + 1$ corresponds to the second end (102) of the transmission line, and $n = 2 \ldots ns$ is the junction (106) between two adjacent sections $n - 1$ (103) and $n$ (104) of the transmission line the time differences being pre-calculated based on the length of and propagation velocity of a traveling wave in each section.

5. The fault protection device according to claim 4, wherein the processing means (203) is further arranged for initiating, in response to determining that a fault occurred in section $n_f$ of the transmission line, protective measures, wherein the protective measures are dependent on a type of section $n_f$.

6. The fault protection device according to claim 5, wherein each section (103, 104) of the transmission line is either one of a cable section (103) or an overhead-line section (104), and wherein the processing means (203) is further arranged for, when initiating protective measures, activating auto-reclosing if section $n_f$ is an overhead-line section and deactivating auto-reclosing if section $n_f$ is a cable section.

**Patentansprüche**

1. Fehlerschutzverfahren in einer Hochspannungs-Leistungsübertragungsleitung (100), die $n_s \geq 2$ Abschnitte (103, 104) enthält, wobei das Verfahren Folgendes umfasst:

   Detektieren an einem ersten Ende (101) der Übertragungsleitung der Ankunft einer fehlerinduzierten (105) Wanderwelle zu einer ersten Ankunftszeit $t_1$,
   Detektieren an einem zweiten Ende (102) der Übertragungsleitung der Ankunft der fehlerinduzierten Wanderwelle zu einer zweiten Ankunftszeit $t_2$,
   Berechnen einer Zeitdifferenz $\Delta t$ zwischen der ersten Ankunftszeit und der zweiten Ankunftszeit, $\Delta t = t_1 - t_2$,
   Bestimmen, dass der Fehler (105) im Abschnitt $n_f$ (103) der Übertragungsleitung auftrat,
   **gekennzeichnet durch**
   Vergleichen der Zeitdifferenz $\Delta t$ mit mehreren vorgegebenen Zeitdifferenzen $\Delta t_n$, wobei $n = 1, ..., n_s + 1$,
   Bestimmen, dass der Fehler (105) im Abschnitt $n_f$ (103) der Übertragungsleitung auftrat, falls $\Delta t_{nf} < \Delta t < \Delta t_{nf+1}$
   wobei jede vorgegebene Zeitdifferenz $\Delta t_n$ die Differenz zwischen der ersten Ankunftszeit und der zweiten Ankunftszeit einer Wanderwelle ist, die **durch** einen Fehler induziert wird, der an einer Verbindungsstelle $n$ (101, 102, 106) auftritt, wobei $n = 1$ dem ersten Ende (101) der Übertragungsleitung entspricht, $n = n_s + 1$ dem zweiten Ende (102) der Übertragungsleitung entspricht und $n = 2 ... n_s$ die Verbindungsstelle (106) zwischen zwei benachbarten Abschnitten $n - 1$ (103) und $n$ (104) der Übertragungsleitung ist, wobei die Zeitdifferenzen im Voraus anhand der Ausbreitungslänge und der Ausbreitungsgeschwindigkeit der Wanderwelle in jedem Abschnitt berechnet werden.

2. Verfahren nach Anspruch 1, das ferner Folgendes umfasst:

   Auslösen von Schutzmaßnahmen in Reaktion auf die Bestimmung, dass im Abschnitt $n_f$ der Übertragungsleitung ein Fehler auftrat, wobei die Schutzmaßnahmen vom Typ des Abschnitts $n_f$ abhängen.

3. Verfahren nach Anspruch 2, wobei jeder Abschnitt (103, 104) der Übertragungsleitung entweder ein Kabelabschnitt (103) oder ein Freileitungsabschnitt (104) ist und wobei beim Beginnen von Schutzmaßnahmen ein automatisches Wiedereinschalten aktiviert wird, falls der Abschnitt $n_f$ ein Freileitungsabschnitt ist, und das automatische Wiedereinschalten deaktiviert wird, falls der Abschnitt $n_f$ ein Kabelabschnitt ist.

4. Fehlerschutzvorrichtung (200) für eine Hochspannungs-Leistungsübertragungsleitung (100), die $n_s > 2$ Abschnitte (103, 104) enthält, wobei die Fehlerschutzvorrichtung Folgendes umfasst:

   erste Mittel (201), um an einem ersten Ende (101) der Übertragungsleitung die Ankunft einer fehlerinduzierten (105) Wanderwelle zu einer ersten Ankunftszeit $t_1$ zu detektieren,
   zweite Mittel (202), um an einem zweiten Ende (102) der Übertragungsleitung die Ankunft der fehlerinduzierten Wanderwelle zu einer zweiten Ankunftszeit $t_2$ zu detektieren,
   Verarbeitungsmittel (203), die dafür ausgelegt sind,
   eine Zeitdifferenz $\Delta t$ zwischen der ersten Ankunftszeit und der zweiten Ankunftszeit, $\Delta t = t_1 - t_2$, zu berechnen,
   zu bestimmen, dass der Fehler im Abschnitt $n_f$ (103) der Übertragungsleitung auftrat,
   **dadurch gekennzeichnet, dass**
   die Verarbeitungsmittel (2013) ferner dafür ausgelegt sind,
   die Zeitdifferenz $\Delta t$ mit mehreren vorgegebenen Zeitdifferenzen $\Delta t_n$, wobei $n = 1 ... n_s + 1$, zu vergleichen,
   zu bestimmen, dass der Fehler im Abschnitt $n_f$ (103) der Übertragungsleitung auftrat, falls $\Delta t_{nf} < \Delta t < \Delta t_{nf+1}$ auftrat,
   wobei jede vorgegebene Zeitdifferenz $\Delta t_n$ die Differenz zwischen der ersten Ankunftszeit und der zweiten Ankunftszeit einer Wanderwelle ist, die durch einen Fehler induziert wird, der an einer Verbindungsstelle $n$ (101, 102, 106) auftritt, wobei $n = 1$ dem ersten Ende (101) der Übertragungsleitung entspricht, $n = n_s + 1$ dem zweiten Ende (102) der Übertragungsleitung entspricht und $n = 2 ... n_s$ die Verbindungsstelle (106) zwischen zwei benachbarten Abschnitten $n - 1$ (103) und $n$ (104) der Übertragungsleitung ist, wobei die Zeitdifferenzen im Voraus anhand der Ausbreitungslänge und der Ausbreitungsgeschwindigkeit der Wanderwelle in jedem Abschnitt berechnet werden.

5. Fehlerschutzvorrichtung nach Anspruch 4, wobei die Verarbeitungsmittel (203) ferner dafür ausgelegt sind, in Reaktion auf die Bestimmung, dass im Abschnitt $n_f$ der Übertragungsleitung ein Fehler auftrat, Schutzmaßnahmen zu beginnen, wobei die Schutzmaßnahmen vom Typ des Abschnitts $n_f$ abhängen.

6. Fehlerschutzvorrichtung nach Anspruch 5, wobei jeder Abschnitt (103, 104) der Übertragungsleitung entweder ein Kabelabschnitt (103) oder ein Freileitungsabschnitt (104) ist und wobei die Verarbeitungsmittel (203) ferner dafür ausgelegt sind, dann, wenn Schutzmaßnahmen begonnen werden, ein automatisches Wiedereinschalten zu aktivieren, falls der Abschnitt $n_f$ ein Freileitungsabschnitt ist, und das automatische Wiedereinschalten zu deaktivieren, falls der Abschnitt $n_f$ ein Kabelabschnitt ist.

**Revendications**

1. Procédé de protection en cas de défaut dans une ligne de transport d'énergie à haute tension (100) comprenant $n_s \geq 2$ tronçons (103, 104), le procédé comprenant :

   la détection, au niveau d'une première extrémité (101) de la ligne de transport, d'une arrivée d'une onde progressive provoquée par un défaut (105) à un premier temps d'arrivée $t_1$,
   la détection, au niveau d'une deuxième extrémité (102) de la ligne de transport, d'une arrivée de l'onde progressive provoquée par le défaut à un deuxième temps d'arrivée $t_2$,
   le calcul d'une différence de temps $\Delta t$ entre le premier temps d'arrivée et le deuxième temps d'arrivée, $\Delta t = t_1 - t_2$,
   la détermination que le défaut (105) s'est produit dans le tronçon $n_f$ (103) de la ligne de transport, le procédé étant **caractérisé par**
   la comparaison de la différence de temps $\Delta t$ à une pluralité de différences de temps préalablement déterminées $\Delta t_n$, où $n = 1 ... n_s + 1$,
   la détermination que le défaut (105) s'est produit dans le tronçon $n_f$ (103) de la ligne de transport si $\Delta t_{nf} < \Delta t < \Delta t_{nf+1}$,
   dans lequel chaque différence de temps préalablement déterminée $\Delta t_n$, représente la différence entre le premier temps d'arrivée et le deuxième temps d'arrivée d'une onde progressive provoquée par un défaut se produisant à une jonction $n$ (101, 102, 106), où $n = 1$ correspond à la première extrémité (101) de la ligne de transport, $n = n_s + 1$ correspond à la deuxième extrémité (102) de la ligne de transport et $n = 2 ... n_s$ représente la jonction (106) entre deux tronçons adjacents $n - 1$ (103) et $n$ (104) de la ligne de transport, les différences de temps étant préalablement calculées en fonction de la longueur de chaque tronçon et de la vitesse de propagation d'une onde progressive dans celui-ci.

2. Procédé selon la revendication 1, comprenant en outre :

   le déclenchement, en réponse à la détermination qu'un défaut s'est produit dans le tronçon $n_f$ de la ligne de transport, de mesures de protection, lesquelles mesures de protection dépendent d'un type du tronçon $n_f$.

3. Procédé selon la revendication 2, dans lequel chaque tronçon (103, 104) de la ligne de transport est soit un tronçon de câble (103), soit un tronçon de ligne aérienne (104), et dans lequel, dans le cadre du déclenchement de mesures de protection, une refermeture automatique est activée si le tronçon $n_f$ est un tronçon de ligne aérienne et une refermeture automatique est désactivée si le tronçon $n_f$ est un tronçon de câble.

4. Dispositif (200) de protection en cas de défaut pour une ligne de transport d'énergie à haute tension (100) comprenant $n_s > 2$ tronçons (103, 104), le dispositif de protection en cas de défaut comprenant :

   un premier moyen (201) de détection, au niveau d'une première extrémité (101) de la ligne de transport, d'une arrivée d'une onde progressive provoquée par un défaut (105) à un premier temps d'arrivée $t_1$,
   un deuxième moyen (202) de détection, au niveau d'une deuxième extrémité (102) de la ligne de transport, d'une arrivée de l'onde progressive provoquée par le défaut à un deuxième temps d'arrivée $t_2$,
   un moyen de traitement (203) configuré pour :

   calculer une différence de temps $\Delta t$ entre le premier temps d'arrivée et le deuxième temps d'arrivée, $\Delta t = t_1 - t_2$,
   déterminer que le défaut s'est produit dans le tronçon $n_f$ (103) de la ligne de transport, le dispositif étant **caractérisé en ce que** le moyen de traitement (2013) est configuré en outre pour
   comparer la différence de temps $\Delta t$ à une pluralité de différences de temps préalablement déterminées $\Delta t_n$, où $n = 1 ... n_s + 1$,
   déterminer que le défaut s'est produit dans le tronçon $n_f$ (103) de la ligne de transport si $\Delta t_{nf} < \Delta t < \Delta t_{nf+1}$,
   dans lequel chaque différence de temps préalablement déterminée $\Delta t_n$ représente la différence entre le premier temps d'arrivée et le deuxième temps d'arrivée d'une onde progressive provoquée par un défaut se produisant à une jonction n (101, 102, 106), où n = 1 correspond à la première extrémité (101) de la ligne de transport, $n = n_s + 1$ correspond à la deuxième extrémité (102) de la ligne de transport et $n = 2 ... n_s$ représente la jonction (106) entre deux tronçons adjacents $n - 1$ (103) et $n$ (104) de la ligne de transport, les différences de temps étant préalablement calculées en fonction de la longueur de chaque tronçon et de la vitesse de propagation d'une onde progressive dans celui-ci.

5. Dispositif de protection en cas de défaut selon la revendication 4, dans lequel le moyen de traitement (203) est configuré en outre pour déclencher, s'il détermine qu'un défaut s'est produit dans le tronçon $n_f$ de la ligne de transport, des mesures de protection, lesquelles mesures de protection dépendent d'un type du tronçon $n_f$.

6. Dispositif de protection en cas de défaut selon la revendication 5, dans lequel chaque tronçon (103, 104) de la ligne de transport est soit un tronçon de câble (103), soit un tronçon de ligne aérienne (104), et dans lequel le moyen de traitement (203) est configuré en outre, dans le cadre du déclenchement des mesures de protection, pour activer une refermeture automatique si le tronçon $n_f$ est un tronçon de ligne aérienne et pour désactiver une refermeture automatique si le tronçon $n_f$ est un tronçon de câble.

EP 2 780 998 B1

Fig. 1

Fig. 2

EP 2 780 998 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

• WO 2011127967 A

### Non-patent literature cited in the description

• Smart re-close scheme of combined overhead line with underground power cable. **ZHENTAO XIN et al.** POWER SYSTEM TECHNOLOGY (POWERCON), 2010 INTERNATIONAL CONFERENCE. IEEE, 24 October 2010, 1-6